# EUROPEAN PATENT APPLICATION

(11) **EP 2 166 454 A1**
(43) Date of publication of application: **24.03.2010**
(21) Application number: 08163862.9
(22) Date of filing: 08.09.2008
(51) Int. Cl.: G06F 11/267

(54) **System and method for testing application-specific blocks embedded in reconfigurable arrays**

(71) Applicant: Panasonic Corporation, Kadoma-shi Osaka 571-8501 (JP)
(72) Inventor: Ottley, Tim, Temple Quay, Bristol BS1 6EA (GB)
(74) Representative: Haley, Stephen

(57) **Abstract**

A method and apparatus for testing an application-specific functional block embedded in a user programmable fabric, the user programmable fabric comprising configuration data control means having an inputs and an outputs and the application-specific functional block having inputs and an outputs. The method comprising the steps of routing the outputs of the configuration data control means of the user programmable fabric to the inputs of the application-specific functional block, sending configuration data to configure the application-specific functional block to the configuration control means of the user programmable fabric, transferring the configuration data to the configuration memory means of the application-specific functional block, sending test data to test the application-specific functional block to the configuration control means of the user programmable fabric and routing the outputs of the configuration data control means of the user programmable fabric to the inputs of the application-specific functional block. The method also includes the steps of testing, using the test data, the application-specific functional block, routing the outputs of the application-specific functional block to the inputs of the configuration data control means of the user programmable fabric and receiving the test output data from the configuration control means of the user programmable fabric.

## Description

The present invention relates to the field of user programmable logic devices. More specifically, the present invention is directed to a method of testing application-specific functional blocks which are embedded in a user programmable fabric.

Reconfigurable devices/fabrics are commonly made up of multiple instances of a single user programmable logic block or tile; the fundamental building block of the system. This arrangement facilitates the use of an easily scalable configuration mechanism of equally regular structure.

The insertion of application-specific functional blocks embedded within the reconfigurable device/fabric is often used to enhance the performance of the device/fabric within specific application contexts.
The incorporation of application-specific functional blocks makes it necessary to provide a system and method of testing these devices *in situ.* Known methods of testing embedded application-specific functional blocks generally fall into three categories.

The first category consists of methods which make use of dedicated access mechanisms for testing the application-specific functional blocks. These methods require the physical presence of additional, separate interface means in the re-configurable device/fabric. An example of a device in this category is an embedded application-specific functional block which comprises a dedicated scan-chain that is fed through the reconfigurable device/fabric.

Devices in this first category have several disadvantages. For example, these devices require separate interface and protocol support access to the application-specific functional blocks. Moreover, the extra logic required to create the interfacing logic, as well as the actual dedicated scan-chain paths incur extra design costs.

The second category of methods for testing embedded application-specific functional blocks includes methods which in some way re-configure the user programmable section of the device/fabric to act as a virtual scan chain within the device/fabric. An example of such a method includes the steps of configuring the reconfigurable device/fabric to implement a virtual scan chain around the embedded device, with part of the virtual scan chain feeding scan data into the embedded device and part of the virtual scan chain receiving the results from the embedded device.

The methods in this category share several common disadvantages. For example, the methods require the use of interconnection logic between the reconfigurable device/fabric and the embedded application-specific functional blocks. This "gasket logic" (e.g. multiplexers) allows the device/fabric to be connected directly to the pins of the application-specific functional blocks. It also however significantly increases the cost and complexity of the resulting device.

Finally, the third category of solution sees the reconfiguration of the device/fabric to act in full, or in part, as a test mechanism for embedded application specific functional blocks. This solution involves implementing a number of different functions (e.g. bus monitoring, bus emulation, built-in self test and debugging) using the reconfigurable device/fabric. Some of the methods included in the third category involve implementing pattern generator logic to validate the results of a given test. A disadvantage with this method is that the reconfigurable device/fabric is connected to the application specific functional block via a BUS. Accordingly, the system will need to use BUS access protocols and will create traffic on the system BUS during testing.

Accordingly, there is a clear need for a system and method of testing embedded application-specific functional blocks which will not result in an undue increase in the cost and complexity of the reconfigurable device/fabric.

In order to solve the problems associated with the prior art, the present invention provides a method of testing an application-specific functional block embedded in a user programmable fabric, the user programmable fabric comprising configuration data control means having inputs and outputs and the application-specific functional block having inputs and outputs, the method comprises the steps of:
routing the outputs of the configuration data control means of the user programmable fabric to the inputs of the application-specific functional block;
sending configuration data to configure the application-specific functional block to the configuration control means of the user programmable fabric;
transferring the configuration data to the configuration memory means of the application-specific functional block;
sending test data to test the application-specific functional block to the configuration control means of the user programmable fabric;
routing the outputs of the configuration data control means of the user programmable fabric to the inputs of the application-specific functional block;
testing, using the test data, the application-specific functional block;
routing the outputs of the application-specific functional block to the inputs of the configuration data control means of the user programmable fabric; and
receiving the test output data from the configuration control means of the user programmable fabric.

The configuration control means may comprise a chain of registers and the step of sending configuration data and the step of sending test data further may comprise the step of:
shifting the data through a chain of registers.

The step of routing the outputs of the configuration data control means may comprise the step of:
enabling the input of the configuration memory means of the application-specific functional blocks.

The method may further comprise the step of:
generating the test data using the user programmable fabric.

The present invention also provides an apparatus for testing an application-specific functional block embedded in a user programmable fabric, the user programmable fabric comprising configuration data control means having inputs and outputs and the application-specific functional block having inputs and an outputs, the apparatus comprises:
routing means for routing the outputs of the configuration data control means of the user programmable fabric to the inputs of the application-specific functional block;
sending means for sending configuration data to configure the application-specific functional block to the configuration control means of the user programmable fabric;
transferring means for transferring the configuration data to the configuration memory means of the application-specific functional block;
sending means for sending test data to test the application-specific functional block to the configuration control means of the user programmable fabric;
routing means for routing the outputs of the configuration data control means of the user programmable fabric to the inputs of the application-specific functional block;
testing means for testing, using the test data, the application-specific functional block;
routing means for routing the outputs of the application-specific functional block to the inputs of the configuration data control means of the user programmable fabric; and
receiving means for receiving the test output data from the configuration control means of the user programmable fabric.

The configuration control means may comprise a chain of registers and the sending means for sending configuration data and the sending means for sending test data may further comprise:
shifting means for shifting the data through a chain of registers.

The routing means for routing the outputs of the configuration data control means may further comprise:
enabling means for enabling the input of the configuration memory means of the application-specific functional blocks.

The apparatus may further comprise:
generating means for generating test data using the user programmable fabric.

As will be appreciated by a person skilled in the art, the present invention provides several advantages over the prior art. For example, the invention facilitates the testing of embedded application specific functional blocks by reusing the same mechanism used to configure the user programmable logic blocks within the reconfigurable array.

An example of the present invention will now be described with reference to the accompanying drawings, in which:
Figure 1 shows a diagram representing a programmable logic device in accordance with the prior art;
Figure 2 shows a diagram representing a programmable logic device comprising an embedded application-specific functional block in accordance with the prior art;
Figure 3 shows a diagram representing a programmable logic device comprising an embedded application-specific functional block in accordance with the prior art;
Figure 4 shows a functional diagram of the testing of application-specific functional blocks via an application configured onto user programmable logic;
Figure 5 shows a diagram representing a programmable logic device in accordance with the present invention;
Figure 6 shows a diagram representing the configuration chain of a device according to the present invention;
Figure 7 shows a diagram representing the configuration chain of a device in accordance with the present invention;
Figure 8 shows a detailed diagram representing the configuration chain of Figure 7;
Figure 9 shows a diagram representing the configuration chain of Figure 6 during a SHIFT operation;
Figure 10 shows a diagram representing the configuration chain of Figure 6 during a WRITE operation;
Figure 11 shows a diagram of a configuration chain in accordance with the present invention writing to the application specific functional block;
Figure 12 shows a diagram representing the desired effective functionality of a device in accordance with the present invention; and
Figure 13 shows a diagram representing the configuration chain of Figure 6 reading from the application specific functional block.

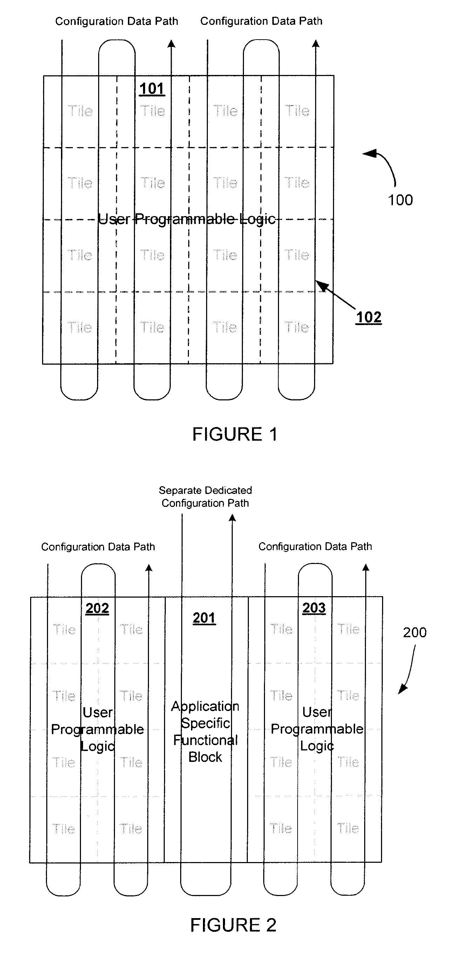

Figure 1 shows a diagram representing a programmable logic device 100 which is made of a plurality of tiles 101. Each tile 101 contains a plurality of configuration registers (not shown) which are linked by a configuration data path 102.

Figure 2 shows a diagram representing a device 200 according to the prior art. The centre portion of the diagram represents an application-specific functional block 201. On either side of the application-specific functional block 201 are sections of user programmable logic 202, 203. Each section of user programmable logic 202, 203 is made up of an array of tiles, as is the case in the device of Figure 1. As can be seen from Figure 2, the configuration data path of the programmable logic sections 202, 203 are completely separate from the configuration path of the application-specific functional block 201. This dedicated configuration path adds to the overall complexity of the device 200.

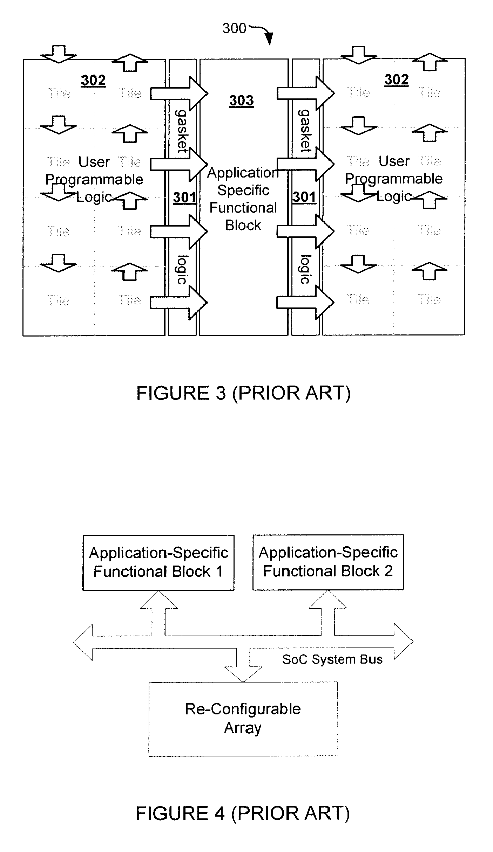

Figure 3 shows a user programmable device 300 in accordance with the prior art which has been programmed to provide a test mechanism for embedded application specific functional blocks. As mentioned above, gasket logic is needed in order to provide an interface between the programmable logic device/fabric 302 and the embedded application-specific functional block 303.

Figure 4 shows a functional diagram of the interconnection between a re-configurable device/fabric which acts as test mechanism for application-specific functional blocks, in accordance with the prior art. This known solution involves implementing a number of different modes, including bus monitoring, bus emulation, built-in-self-test and debugging functions. Some of these modes involve implementing pattern generator logic to feed test data into the application-specific functional block and result capture logic to validate the test results. The bus-based functions must be specified because some of the application-specific functional blocks are attached via system busses, as shown in Figure 4.

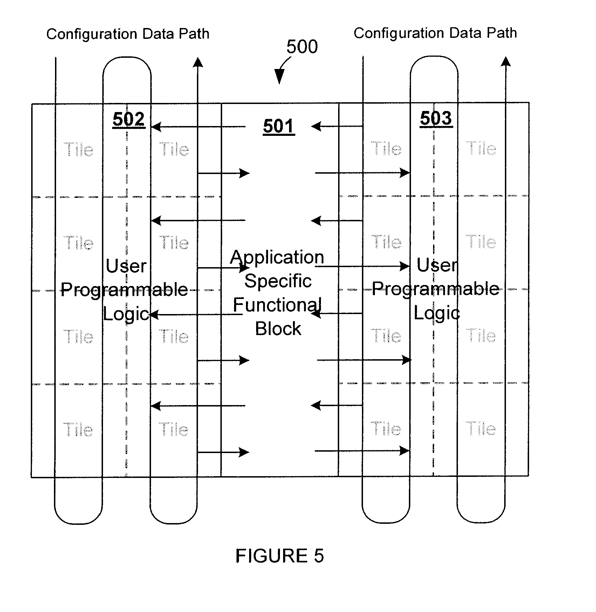

Figure 5 shows a device 500 in accordance with one example of the present invention. Again, the centre portion of the diagram represents an application-specific functional block 501 and, on either side of the block 501 are user programmable logic blocks 502, 503. However, although the user programmable logic blocks 502, 503 each have their own configuration data paths, the application-specific functional block 501 is tested using the programmable logic block data paths.

In order to test an embedded application-specific functional block within a re-configurable device/fabric, the existing configuration mechanism used for the user programmable logic section is reused in a different way. This provides a common interface to both which is independent of the number, location and type of embedded application-specific functional blocks.

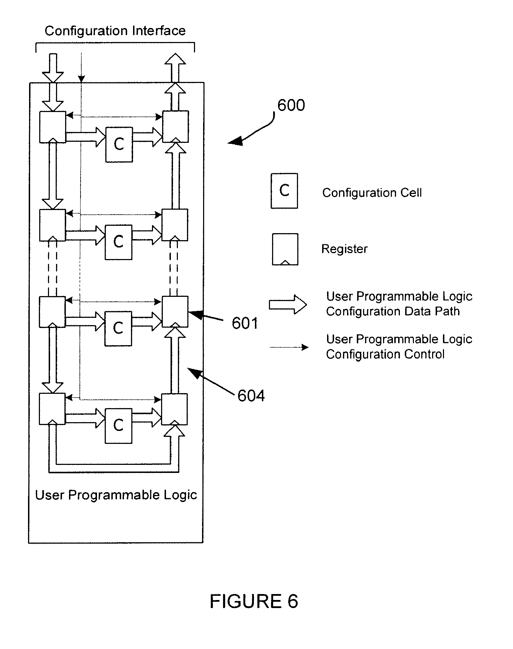

In order to better describe the invention, a detailed account of the configuration of a user programmable logic block of a system in accordance with the present invention will now be described. Figure 6 shows a user programmable logic block 600 comprising internal registers 601 which are chained together using either dedicated configuration wires or wires which form part of the general routing network of the re-configurable device/fabric. In operation, configuration data is shifted along the chains 604 until each register 601 on the chain contains data. This occurs under the control of configuration control signals which may also be fed into the device/fabric via chains of internal registers. However, it is likely that all registers on a particular chain will be addressed/accessed in the same way at any given time so control data may be distributed via semi-global non-registered signals to all stages of the configuration data chain. The control information is then decoded at each stage to perform read/write/shift operations on the data in the configuration chains and related configuration cells 601 within the programmable logic blocks.

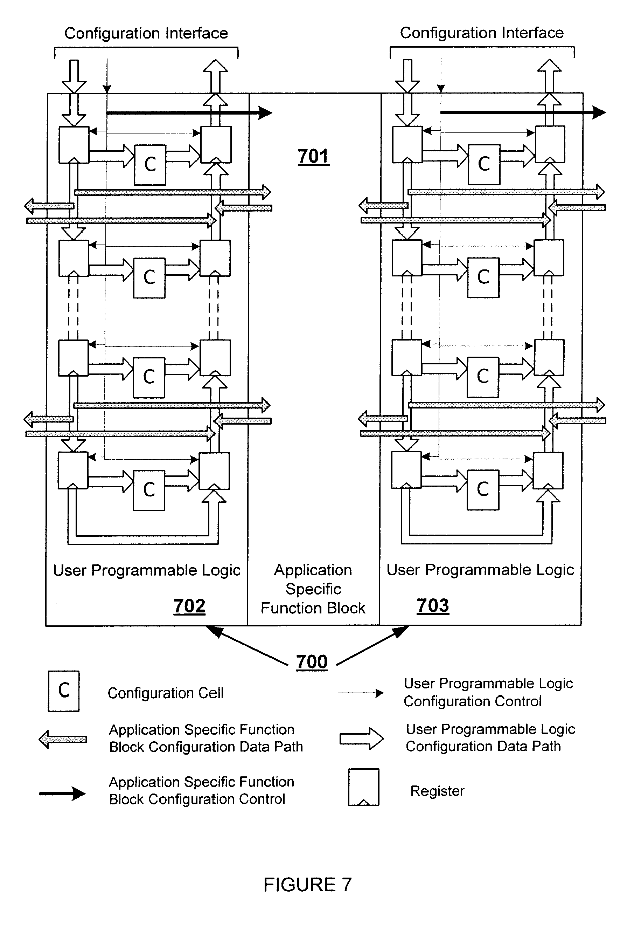

Now, with reference to Figure 7, a method in accordance with the present invention will now be described. In order to test the embedded application-specific functional blocks 701 within the re-configurable device/fabric 700, the inputs and outputs of the application-specific functional block 701 are connected via existing routing paths to the configuration chains within the user programmable logic blocks 702, 703. In addition, the control signals of the user programmable logic blocks 702, 703 are also decoded in order to be provided to any application-specific functional blocks which may occupy an adjacent position within the re-configurable device/fabric. This will be used as an enabling signal to enable the application-specific functional block operation signal. When this signal is asserted, the application-specific functional block will perform the operation requested by the remaining configuration interface signals.

If there is no adjacent application-specific functional block, then the additional control outputs and the existing configuration data paths that would have been used by the missing application-specific functional block will instead be connected into the adjacent user programmable logic block. If this is the case, the neighbouring block will ignore any configuration data on the existing routing network driven by its immediate neighbour while the device/fabric is in configuration mode. The additional control output supplied by the blocks of user programmable logic may or may not be used to facilitate more advanced configuration options.

Configuration chain based testing of embedded application-specific functional blocks is achieved by the following method. The first step consists of configuring the application specific functional block into a particular test state. To do this, predefined data is shifted into the configuration chains within the adjacent user programmable logic blocks 702, 703 using a series of shift operations.

The array is then switched out of configuration mode and into run mode and the array clock is enable for one cycle. This will cause the application specific functional block to start processing the data that is on its input ports.

Once this is done, the array is switched back into configuration mode and further data is written into the configuration chain, as required. As new input data is shifted into the chain, the application specific functional block output data from the previous clock cycle is shifted out of the end of the configuration chain at the same time.

The above sequence can be repeated as many times as required, with varying configuration data, until all operating modes of the application-specific functional block have been tested, and all results data compared against expected results.

When configuring application specific functional blocks, configuration chains located within user programmable logic on either side may need to be accessed together in a synchronised manner depending on the configuration chain topology.

Alternatively, data written into an application specific functional block may come from a configuration chain within a user programmable logic block on a first side whilst the results data may be read via a configuration chain within the user programmable logic block on a second side.

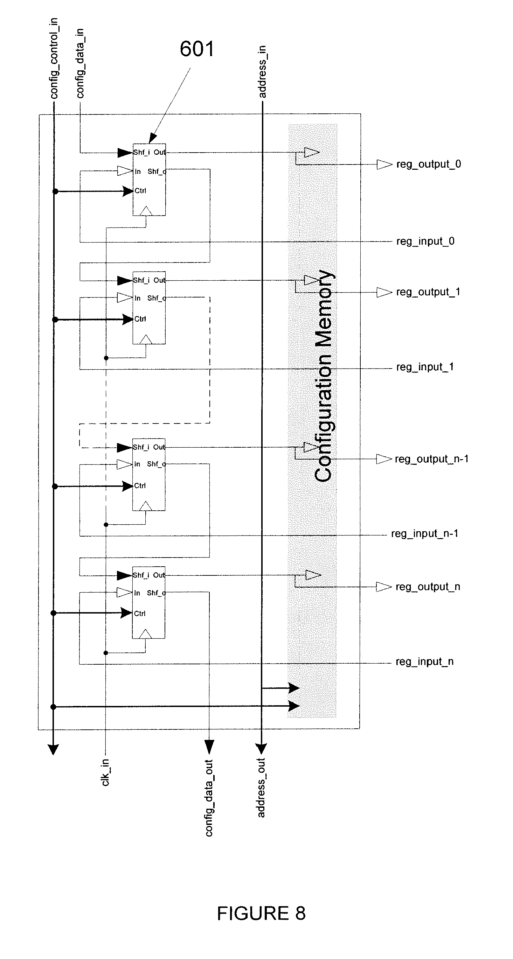

Now, with reference to Figure 8 to 13, a more detailed example of how the application specific functional block is configured will now be described. The number of configuration chains within the entire user programmable logic section of the fabric will vary depending on the particular architecture (e.g. the width of the registers, the relative positions within a chain of the registers and the length of each chain). Figure 8 shows an example of a configuration chain containing n registers. The inputs and outputs of such a block may be connected to preceding and subsequent blocks to created longer chains, as desired.

As shown in Figure 8, this particular configuration chain is formed by a series of register cells 601. Each cell accepts inputs from two sources and outputs its current state to two separate outputs. Active inputs are selectable via the control input. Additionally each register cell 601 may retain its present state and ignore both input values. This type of register cell may be a specially designed flip-flop or a combination of a register and sequential logic.

The above chain structure then allows a number of operations to be performed in response to a specific value of the control input, examples of which are shown in the following table.

| | |
|---|---|
| NOP | Perform "no operation". Each register retains its current state. The register Ctrl input is asserted such that neither input is active. |
| SHIFT | Data is shifted along each chain, each register passes its current value to the next register in the chain. The register Ctrl input is asserted such that the input connected to the previous register in the chain is active. |
| READ | Data from within the user programmable logic blocks (register data, memory data, configuration data etc) is loaded into the configuration chain. The register Ctrl input is asserted such that the input driven from the user programmable logic block (memory, register, config cell etc) is active. |
| WRITE | Data within each configuration register is copied to a location (register, memory, configuration cell etc) within the user programmable logic blocks. The Address is internally decoded and enables the inputs to the addressed target destination (register, memory, configuration cell etc). |

Using the above operations, it is possible to program the user configurable logic blocks. In this specific example, this is achieved by performing the following sequence of operations.

First, the address of the required configuration cell 601 location must be asserted to the address inputs. This is done at the beginning of the sequence to allow the address to propagate over the long distances of the fabric (the address bus is not registered in this example but may be in other architectures).

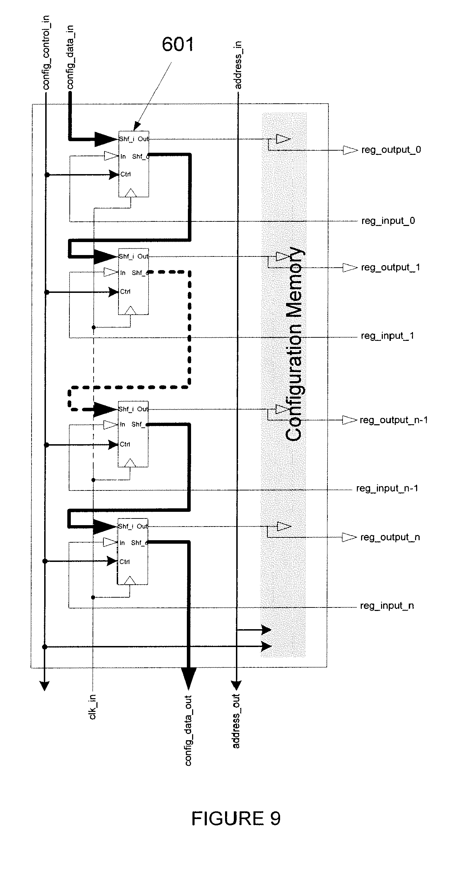

Secondly, the required data is shifted into the configuration chain(s) using the SHIFT operation. As shown in Figure 9, during SHIFT operations, it is the register cells than are sensitive to the Configuration Control input ("config_control_in"). The active data path is in bold in Figure 9. Then, the above is repeated until the entire configuration chain contains valid test data. Then one or more NOP operations are performed in order to allow the data outputs of each register 601 on the configuration chain to propagate through the user programmable logic block. This last operation is a precautionary measure and may not be required.

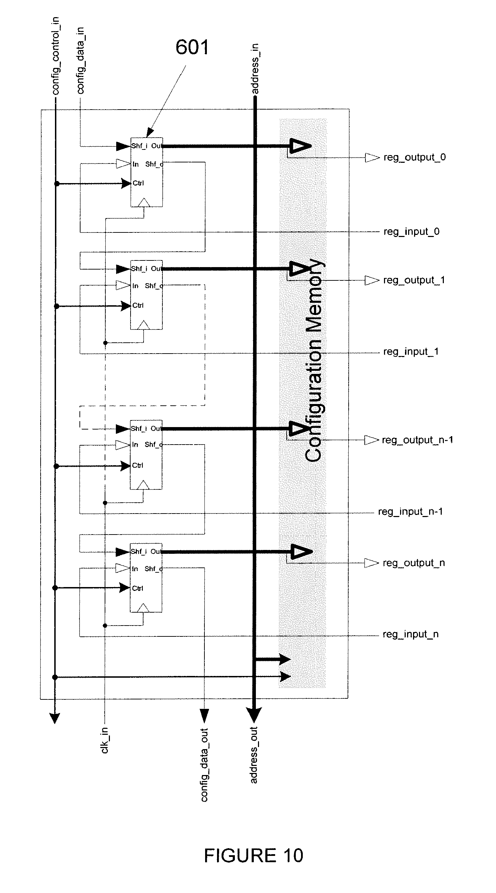

The next step consists of performing a WRITE function using the data contained within the configuration chain registers 601. As shown in Figure 10, during the WRITE operation it is the Configuration Memory (registers, memory, configuration cell etc) that is sensitive to the Configuration Control input ("config_control_in") enabling the decoded Address to activate the inputs to the addressed location. Again, the active data path is in bold in Figure 10.

As will be appreciated, application specific functional blocks can be anything from complex logic functions to RAM blocks. Accordingly, each application specific functional block will have different features or modes that need to be configured before use. These configuration settings will be stored in configuration registers within each application specific functional block. These configuration registers are only accessible via the application specific functional block input/output ports the application specific functional block is in configuration mode. When the application specific functional blocks are in non-configuration mode, the input/output ports are switched to connect to their internal logic functions and/or RAM for normal run-mode use.

Now, again with reference to Figure 8, the method of reading the configuration memory of each user programmable logic block will now be described.

The first step in this method is to assert the address of the required configuration cell location to the address inputs. Then, one or more NOP operations are performed in order to allow the address to propagate over the long distances of the fabric. Again, although, in this example the address bus is not registered, it may be in other architectures.

The next step in the method is reading the data at the addressed configuration memory location within each block into the registers 601 on the configuration chain. This is done using the READ operation.

Then, the read data is shifted along the configuration chain, each data word emerging from the end (output) of the chain being stored. This is done using the SHIFT operation. This SHIFT operation is repeated until all read data has been output from the chain. The steps of the above method are then repeated until all configuration locations have been read.

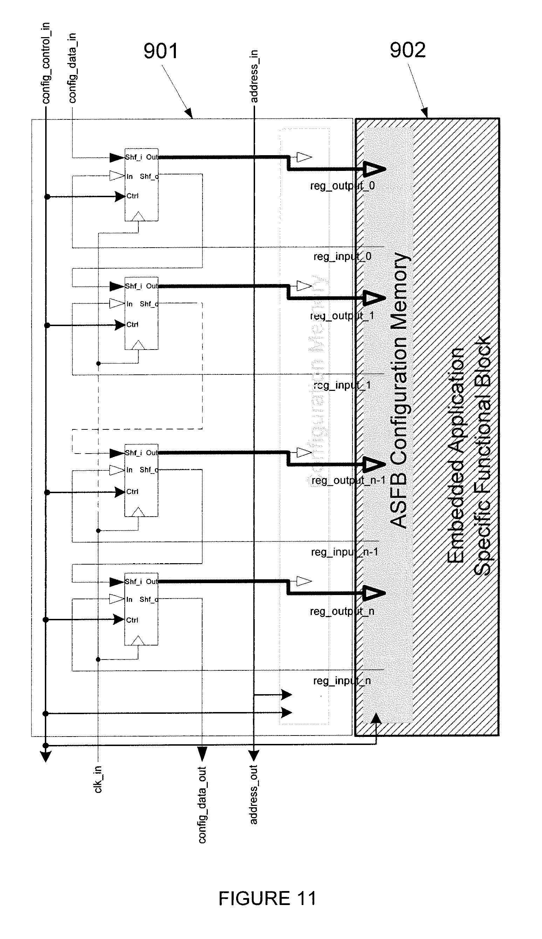

Now, with reference to Figures 11 to 13, the method of testing the embedded application functional blocks according to one embodiment of the present invention will now be described.

Figure 11 shows how the user programmable logic blocks 901 interact with embedded application-specific functional blocks 902 by way of their existing configuration chains. Existing wires in the routing network between the two blocks used for run time communication are again reused during testing. This means that instead of supplying each embedded application-specific functional block 902 with its own configuration interface (configuration chains, address bus and control input) the existing configuration circuitry within the user programmable logic blocks 901 is used as a transport mechanism for the test data/control required to exercise the embedded application-specific functional blocks.

This produces an indirect testing scheme where all control/data required to test the embedded application functional blocks 902 is treated as configuration data by the configuration mechanism and then transferred to the embedded functional blocks by existing data paths. It is then down to the embedded functional block 902 itself to interpret the control and data correctly while in configuration mode.

Thus, "reg_input_x" and "reg_output_x" signals are mapped to the inputs and outputs shown In Figure 10. The number of registers available in the user programmable logic blocks and their width must be sufficient to supply enough data/address/command bits to each embedded block, the details of which are implementation and architecture specific.

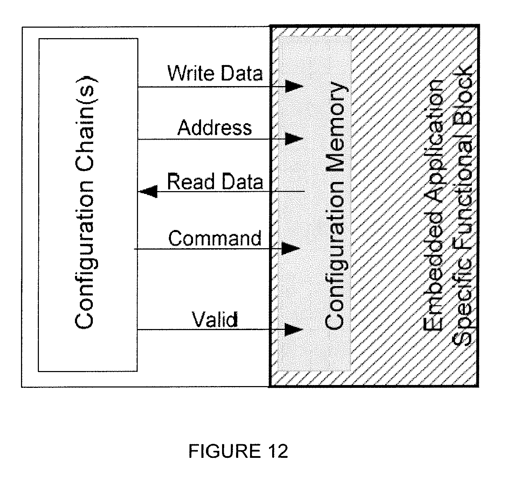

In order for the data on the signals shown in Figure 12 to be interpreted at the correct time, additional values (operations) for the Configuration Control Input ("config_control_in") of the user programmable logic blocks are required in order to signal that access to the embedded functional blocks will occur. For example, an EMBEDDED_ACCESS operation should be defined.

In addition, the Configuration Control Output signal "config_control_output" from each user programmable logic block must also be input to each application-specific embedded functional block as well as being input to the next programmable logic block. During an EMBEDDED_ACCESS operation, only the embedded application-specific functional block is sensitive to the Configuration Control signal.

As shown in Figure 12 the following signals are required (their width being architecture and implementation specific).

| | |
|---|---|
| Write Data | Configuration data to be written into the embedded functional blocks configuration memory (register, memory, configuration celletc) at the location indicated by 'Address'. |
| Read Data | Configuration data to be read from the configuration memory within the (register, memory, configuration cell etc) embedded functional blocks from the address indicated by 'Address'. |
| Address | Indicates which memory location is to be accessed during the current operation. |
| Command | Defines the configuration operation to be performed on the embedded functional blocks. The following are examples of the essential commands: **EB_NOP -** No operation, this is useful as multiple embedded functional blocks may be configured from the same configuration chain. But not all may require configuration for a given application. **EB_WRITE -** The 'Write Data' presented to the embedded functional block should be written to 'Address'. **EB_READ -** The data currently at 'Address' should be read and placed on 'Read Data'. |
| Valid | This signal is driven by the Configuration Control (when asserted to EMBEDDED_ACCESS) within the user programmable logic block. When asserted, the embedded functional block will become sensitive to its inputs and perform a configuration operation as defined by 'Command' |

In this example of the present invention, the method for configuring an embedded application-specific functional block 902 have the following steps.

First, using the SHIFT operation, control, address and configuration data is shifted into the associated configuration chain(s) in order for the application-specific functional blocks 902 to be written by the chains. In this example, the address of the memory location, the data to be written and the command to be performed, EB_WRITE are shifted from one register to the other. This last step is repeated until all the required configuration and control data has been shifted into the chain.

Then, one or more NOP operations are performed to allow the data outputs of each register on the configuration chain to propagate through the user programmable logic block. Again, this is a precautionary measure and may not be required in other examples of the present invention.

The next step in the method is to perform an EMBEDDED_ACCESS operation on the configuration chain triggering the application-specific functional blocks 902 to enable their configuration inputs and therefore, in this instance, perform the required EB_WRITE operation. Then, one or more NOP operations are performed in order to allow the embedded application-specific functional blocks 902 to complete the current operation (EB_WRITE). Finally, the above steps are repeated for each configuration address locations within the application-specific embedded blocks 902.

Now, the method of reading configuration data back from the application-specific embedded blocks will now be described.

First, a SHIFT operation is performed in order to shift the required control, address and configuration data into the associated configuration chain(s) for the application-specific functional blocks 902 to be read by the chain(s). In this case the address of the memory location, the data to be read and the command to be performed, EB_READ. This step is repeated until all the required configuration and control data has been shifted into the chain.

Then, one or more NOP operations are performed in order to allow the data outputs of each register on the configuration chain to propagate through the user programmable logic block. Again, this is merely a precautionary measure.

An EMBEDDED_ACCESS operation is then performed on the configuration chain triggering the application-specific functional blocks 902 to enable their inputs, and therefore perform the required operation, a EB_READ in this instance.

Then, one or more NOP operations are performed in order to allow the embedded application-specific functional blocks 902 to complete the current operation (EB_READ) and present the read data on their outputs.

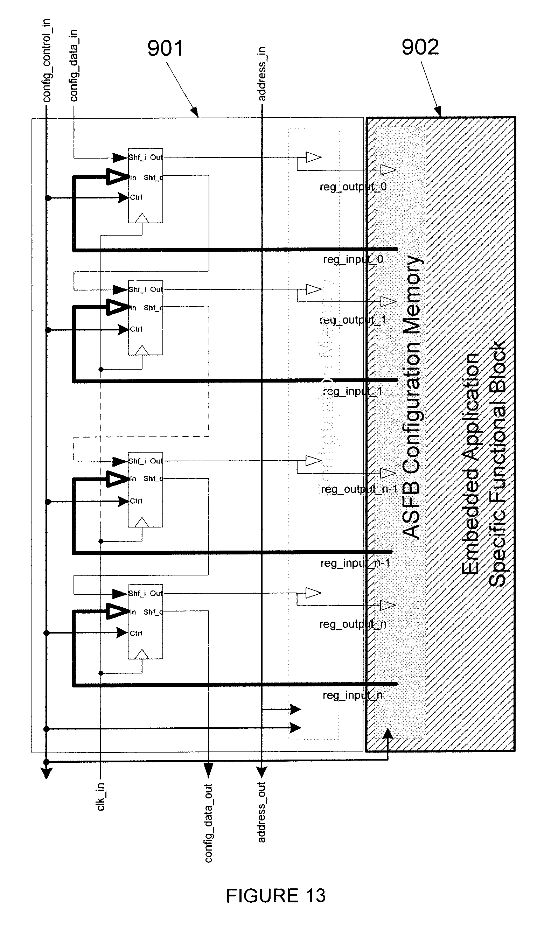

Once this is done, an UPDATE_CHAIN operation on the configuration chain is performed. This is similar to a READ operation described earlier but data from the embedded functional block is routed to the register inputs on the configuration chain, as shown in by the bold data lines in Figure 13.

Then, the configuration chain is shifted using the SHIFT operation and the output data words are stored. This step is repeated until all data is read from the configuration chain(s). Finally, the steps of the above method are repeated for every address locations within the application-specific embedded blocks.

In order to test an application specific functional block, it is first configured in a particular mode, as described above. Then, it is switched into a NOP state. At that point, the user programmable logic block registers will have user programmable logic data shifted down them until the correct data is in the correct registers 601.

Then a WRITE command is issued to the user programmable logic blocks, which will enable the connections between the adjacent user programmable logic registers and the I/O ports of the application specific functional block under test. The user programmable logic blocks configuration registers will then have application specific functional block test-data shifted down them until the appropriate application specific functional block inputs are supplied with the correct test values from their associated registers 601, in the same way as initialisation data is fed through the chain above.

Then, the user programmable logic chains are switched to a NOP state in order to hold the appropriate test-data values on the appropriate application specific functional block inputs. The entire array is then switched from CONFIG to RUN-MODE for one or more clock cycles, and then switched back to CONFIG-MODE. After this, the application specific functional block is held in a NOP state to hold its results data on its output ports. The user programmable logic chains are then switched to SHIFT mode and a sequence of SHIFT operations enables the captured data to be shifted out of the array for analysis. As described above, in order to test a directly-connected application-specific functional block using the user programmable logic, the reconfigurable array is placed into configuration mode and a test application is shifted into the configuration chains.

The implementation of a Pattern Generator (PG) can vary depending on the nature and function of the application specific functional block. One implementation involves using a Linear-Feedback-Shift-Register (LFSR) to generate a pseudo-random sequence of inputs. The choice of LFSR equation can be made during simulation of the application specific functional block, in order to ensure that suitable test coverage is achieved.
Another implementation of the PG entails using a Finite State Machine (FSM) to produce a selected sequence of test inputs to the application specific functional block. This solution is reasonably compact for a small number of different input combinations.

A further implementation of the PG involves using a block-RAM embedded elsewhere within the reconfigurable array to store larger numbers of input test vectors. For this implementation, an FSM is used, possibly with counter logic, to generate address values to enable the FSM to read out the test vectors from the block-RAM and apply them in sequence to the application specific functional block.

The implementation of the Results Capture (RC) logic can vary depending on the nature and function of the application specific functional block. One implementation uses a Multiple-Input-Signature-Register (MISR) which is like a LFSR but which takes all the outputs from the application specific functional block and merges them into the MISR structure. Once the test has been run, for the required number of clock cycles, the output of the MISR is a binary sequence. This sequence is then compared against the sequence obtained from a simulated run of the test, and used to indicate whether the test is a pass or fail.

Another implementation of the RC entails using a Finite State Machine (FSM) to generate a defined sequence of outputs which simulation has shown the application specific functional block should produce. Then the output of the FSM and the application specific functional block can be compared on a clock-by-clock basis, or on selected clock cycles, as is appropriate for the test. If all the comparisons match, then the test is deemed to have passed. This solution is also reasonably compact for a small number of different output combinations.

A further implementation of the RC involves using a block-RAM embedded elsewhere within the reconfigurable array to store larger numbers of output test vectors. An FSM is used, possibly with counter logic to generate address values to enable the FSM to read out the output test vectors from the block-RAM and compare them in sequence with the output of the application specific functional block. If all the comparisons match, then the test is deemed to have passed.

## Claims

1. A method of testing an application-specific functional block embedded in a user programmable fabric, the user programmable fabric comprising configuration data control means having inputs and outputs and the application-specific functional block having inputs and outputs, the method comprising the steps of:
routing the outputs of the configuration data control means of the user programmable fabric to the inputs of the application-specific functional block;
sending configuration data to configure the application-specific functional block to the configuration control means of the user programmable fabric;
transferring the configuration data to the configuration memory means of the application-specific functional block;
sending test data to test the application-specific functional block to the configuration control means of the user programmable fabric;
routing the outputs of the configuration data control means of the user programmable fabric to the inputs of the application-specific functional block;
testing, using the test data, the application-specific functional block;
routing the outputs of the application-specific functional block to the inputs of the configuration data control means of the user programmable fabric; and
receiving the test output data from the configuration control means of the user programmable fabric.

2. The method of claim 1, wherein the configuration control means comprises a chain of registers and wherein the step of sending configuration data and the step of sending test data further comprise the step of:
shifting the data through a chain of registers.

3. The method of any of claims 1 and 2, wherein the step of routing the outputs of the configuration data control means comprises the step of:
enabling the input of the configuration memory means of the application-specific functional blocks.

4. The method of any of the preceding claims, further comprising the step of:
generating the test data using the user programmable fabric.

5. An apparatus for testing an application-specific functional block embedded in a user programmable fabric, the user programmable fabric comprising configuration data control means having inputs and outputs and the application-specific functional block having inputs and an outputs, the apparatus comprising:
routing means for routing the outputs of the configuration data control means of the user programmable fabric to the inputs of the application-specific functional block;
sending means for sending configuration data to configure the application-specific functional block to the configuration control means of the user programmable fabric;
transferring means for transferring the configuration data to the configuration memory means of the application-specific functional block;
sending means for sending test data to test the application-specific functional block to the configuration control means of the user programmable fabric;
routing means for routing the outputs of the configuration data control means of the user programmable fabric to the inputs of the application-specific functional block;
testing means for testing, using the test data, the application-specific functional block;
routing means for routing the outputs of the application-specific functional block to the inputs of the configuration data control means of the user programmable fabric; and
receiving means for receiving the test output data from the configuration control means of the user programmable fabric.

6. The apparatus of claim 5, wherein the configuration control means comprises a chain of registers and wherein the sending means for sending configuration data and the sending means for sending test data further comprise: shifting means for shifting the data through a chain of registers.

7. The apparatus of any of claims 5 and 6, wherein the routing means for routing the outputs of the configuration data control means comprises:
enabling means for enabling the input of the configuration memory means of the application-specific functional blocks.

8. The apparatus of any of claims 5 to 7, further comprising:
generating means for generating test data using the user programmable fabric.
